# EUROPEAN PATENT APPLICATION

(11) **EP 1 096 759 A1**
(43) Date of publication of application: **02.05.2001**
(21) Application number: 00917298.2
(22) Date of filing: 12.04.2000
(51) Int. Cl.: H04M 1/02, H04M 1/18, H05K 5/02, B29C 45/26, B29L 31/00

(54) **PORTABLE PHONE AND METHOD OF FORMING WATERPROOF CASE OF THE PHONE**

(30) Priority: 13.04.1999 JP 10550299
(71) Applicant: MATSUSHITA ELECTRIC INDUSTRIAL CO., LTD., Kadoma-shi, Osaka 571-0050 (JP)
(72) Inventor: Kuchiishi, Koji, Kawasaki-shi, Kanagawa 211-0005 (JP); Takahashi, Akira, Yokohama-shi, Kanagawa 224-0041 (JP); Nagano, Katsumi, Yokohama-shi, Kanagawa 222-0003 (JP)
(74) Representative: Grünecker, Kinkeldey, Stockmair & Schwanhäusser Anwaltssozietät
(86) International application number: JP0002391
(87) International publication number: WO0062509

(57) **Abstract**

At the periphery of a joint surface (11) formed of hard material (1) and hard material (2) of an upper case (12) and a lower case (13), a waterproof rib (7) formed of soft material and an waterproof groove (8) formed of soft material opposed to the rib are provided integrally with the hard material (1) and the hard material (2), respectively. Further, soft materials (9) and (28) that protrude more than the hard materials (1) and (2) are formed on the surfaces of the upper and lower cases (12) and (13).

## Description

### Field of the Invention

The present invention relates to a portable telephone unit, and particular to a portable telephone unit in which waterproof ability, assembly ability and shock-resistance are improved.

### Background of the Invention

Recently, a portable telephone unit that has been made lighter and smaller is frequently exposed to the tough conditions such as sinking in water, dropping or the like as it is handy to carry. Therefore, improvements of waterproof ability, and shock-resistance are being required. A telephone unit having the waterproof structure, which has been disclosed in, for example, Japanese Patent Publication No. Hei. 8-32658, has been proposed, in which a waterproof packing formed of soft material is constituted integrally with a plastic frame and a metal wire and interposed between upper and lower cases.

Further, another telephone unit, as disclosed in Japanese Patent Publication No. Hei. 6-268724, has been proposed, in which soft material is integrally formed on a part of an inner surface of an upper case formed of hard resin, a joint surface thereof to a lower case, and surface corners thereof thereby to provide the water proof structure and the strong structure in relation to shock from corner portions.

However, in the telephone unit according to the above conventional art, in case that a packing constituting member is added, the number of parts increases, which causes a problem that the assembling steps increase. Further, in the conventional art in which the waterproof ability is obtained by compressing the packing formed of the soft material by the opposite hard material, the deforming amount of a size enough to waterproof must be obtained by transformation of the packing formed of the soft material. Therefore, a large repulsion power is produced, so that there is a problem that a clearance between the upper and lower cases is easy to be produced.

Further, in the conventional constitution in which the soft resin is integrally formed on a part of the inner surface of the case formed of the hard resin, the joint surface thereof, and the surface thereof, a shape of a cavity of a mold and that of a core thereof are different between at the hard resin molding time and at the soft resin molding time. Therefore, a dedicated mold for molding of the hard resin and a dedicated mold for molding of the soft resin are required. That is, the conventional constitution cannot help depend on a manufacturing method of so-called insert molding in which a case formed of hard material that has been previously formed by a dedicated mold is placed in another mold and soft material is integrally formed on the desired portions of the case.

However, in the insert molding, there is dispersion in the shape of the previously formed hard material due to molding condition or change of temperature after taking-out, which causes flash and short mold at the sort material molding time and causes low yield.

Further, the insert molding requires a plurality of molds and taking-out of the parts at the molding time is performed many times, so that there are also problems of increase of mold cost and of low productivity. Further, in the telephone unit according to the conventional art, regarding dropping from the corners covered with the soft material, the shock-resistance is taken into consideration. However, regarding dropping from other portions where the hard material is exposed, the shock-resistance is not at all taken into consideration.

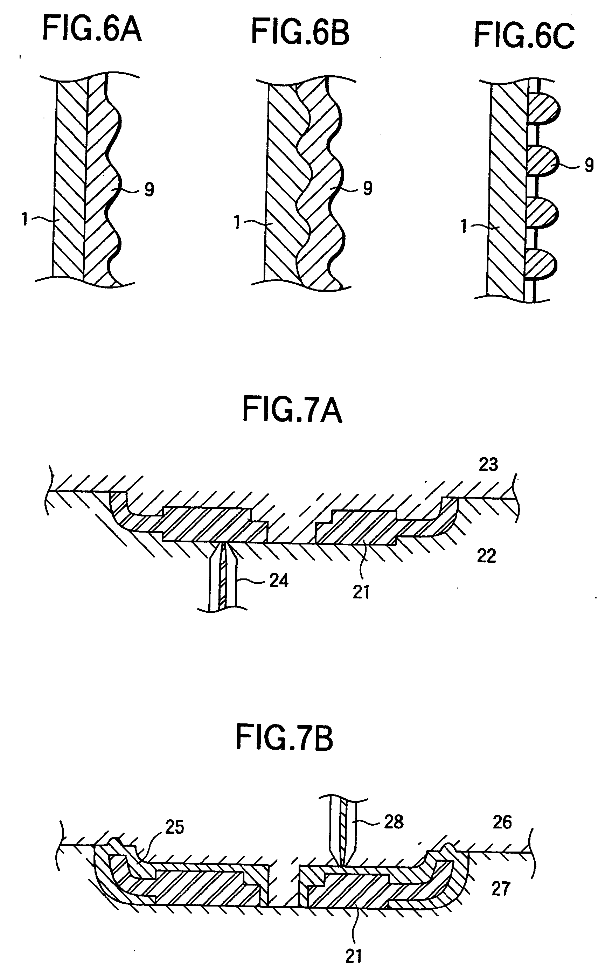

Referring to Fig. 7, the constitution and manufacturing method of the telephone unit according to the conventional art will be described. Fig. 7A shows a shape of a case and mold constitution at a hard material molding (primary molding) time, and Fig. 7B shows a shape of a case and mold constitution at a soft material molding (secondary molding) time. In Fig. 7A, there are shown a shape of the firstly formed hard resin 21, a cavity shape 22 constituting the hard resin shape 21, a core shape 23 constituting the hard resin shape 21, and an arranging example of a gate 24 from which the hard resin is filled into the hard resin shape 21. Further, in Fig. 7B, there are shown a shape of soft resin 25 formed integrally with the hard resin shape 21, a cavity shape 27 constituting the soft resin shape 25, a core shape 26 constituting the soft resin shape, and an arranging example of a gate 28 from which the soft resin is filled into the soft resin shape 25.

As known from Figs. 7A and 7B, in the portable telephone unit according to the conventional art, the soft resin is integrally formed on any of a surface of the hard material portion 21 of a case, an inner surface thereof and a joint surface thereof. Therefore, the shapes of the case inside, the joint surface and the surface are different between before molding of the soft material and after molding thereof, so that any of the molds 22, 23, 26 and 27 cannot be used in common. Accordingly, in order to improve the waterproof structure and the shock-resistance by the conventional art, it is necessary to individually mold the hard material and the soft material using the individual mold.

### Disclosure of the Invention

The present invention has been made in order to solve the above conventional problems. Its object is to provide a portable telephone unit in which excellent waterproof ability and shock-resistance are realized while productivity of parts is being maintained, and in which cost is reduced by reducing the number of parts, mold cost and the assembling steps.

In order to achieve this object, the invention is firstly characterized in that a waterproof rib formed of a soft material is formed integrally with hard material on the periphery of a joint surface of upper and lower case formed of the hard material, that is, on a cavity side of a mold. Further, the invention is secondly characterized in that a waterproof groove opposed to the aforesaid waterproof rib is formed of the soft material. Further the invention is thirdly characterized in that a leading end shape of the aforesaid waterproof rib is formed of a fan-shaped section.

Further, the invention is fourthly characterized in that the soft material that protrudes more than the hard material is formed on surfaces of the upper and lower cases formed of the hard material. Further, the invention is fifthly characterized in that the soft material formed on the surfaces of the upper and lower cases has a plurality of convexities, and sixthly characterized in that a grip portion of the upper and lower case is covered with the soft material.

The portable telephone unit according to the first aspect of the invention comprising the waterproof rib formed of the soft material is formed integrally with the aforesaid hard material on the periphery of the joint surface of the upper and lower cases formed of the hard material, that is, on the cavity side of the mold, and that the aforesaid waterproof rib is fitted into the waterproof groove opposed to the above rib, thereby to join the upper and lower cases water-tightly to each other. Since the molding of the hard material and the integral molding of the waterproof rib formed of the soft material can be simultaneously performed using the same mold, there are effects that the waterproof ability and the productivity of parts are improved, and that the number of parts, the mold cost, and the assembling steps can be reduced.

Further, the second aspect of the invention is a portable telephone unit according to the first aspect of the invention, wherein the waterproof groove opposed to the aforesaid waterproof rib is formed of the soft material. Since the waterproof groove that compresses the waterproof rib is formed of the soft material, even if the deforming amount of a size enough to waterproof is given to the water proof rib, the transformation of the waterproof rib is relaxed by the transformation of the waterproof groove, whereby repulsion power is reduced and there is an effect that a clearance between the upper and lower cases is difficult to be produced.

Further the third aspect of the invention is a portable telephone unit according to the first aspect of the invention, wherein the leading end shape of the aforesaid waterproof rib is formed of a fan-shaped section. The mold cavity slide that has been subjected to machining of the fan-shaped section is fitted to a straight surface of the mold core, whereby the shape of the waterproof rib can be constituted. Therefore, there are effects that the shape of the mold core can be simplified and that fitting of the cavity slide and the core can be simplified.

Further, the portable telephone unit according to the fourth aspect of the invention comprising the soft material that protrudes more than the hard material is formed on surfaces of the upper and lower cases formed of the hard material. Since the soft material that protrudes more than the hard material is formed on surfaces of the upper and lower cases formed of the hard material, even when the telephone unit drops from other portions than its corners, the protruding soft material strikes against matter earlier than the hard material. Therefore, there is an effect that the shock-resistance can be improved more.

Further, the invention according to fifth aspect of the invention is the portable telephone unit according to the fourth aspect of the invention, wherein the soft material formed on the surfaces of the upper and lower cases has a plurality of convexities. Since the leading ends of the convexities are deformed sufficiently and the shock is relaxed when the portable telephone unit drops, there is an effect that the shock-resistance can be improved more.

Further, the invention according to the sixth aspect of the invention is the portable telephone unit according to the first aspect of the invention comprising the soft material covering the grip portion of the upper and lower case. Since the grip portion is covered with the soft material that is hard to slip, there is an effect that the grip ability can be improved.

Further, in the manufacturing method of the portable telephone unit according to the eight aspect of the invention, comprising steps of using the mold core in common at the hard material molding time and at the soft material molding time, and moving the common core alternately between the cavity for the soft material molding and the cavity for the hard material molding, whereby the hard material and the soft material can be molded simultaneously and integrally using the same mold. Since the simultaneous molding can be performed using the same mold, there are effects that both the waterproof ability and productivity of parts can be improved and that the number of parts, the mold cost, and the assembling steps can be reduced.

### Brief Description of the Drawings

Fig. 1 is a perspective view showing the constitution of a portable telephone unit according to an embodiment of the invention.
Fig. 2 is a sectional view of the portable telephone unit taken along a line A-A in Fig. 1.
Fig. 3 is a sectional view of the portable telephone unit taken along a line B-B in Fig. 1.
Fig. 4 is a sectional view taken along a line B-B in Fig. 1, showing the mold constitution when hard resin of an upper case is molded.
Fig. 5 is a sectional view taken along a line B-B in Fig. 1, showing the mold constitution when soft resin of the upper case is molded.
Figs. 6A, 6B, and 6C are sectional views in a second embodiment of the invention when a side surface of the case is cut in parallel with a joint surface.
Fig. 7A is a diagram showing a case shape and mold constitution at a conventional hard material molding (primary molding) time, and Fig. 7B is a diagram showing a case shape and mold constitution at a conventional soft material molding (secondary molding) time.

### Embodiments of the Invention

Embodiments of the invention will be described below with reference to drawings.

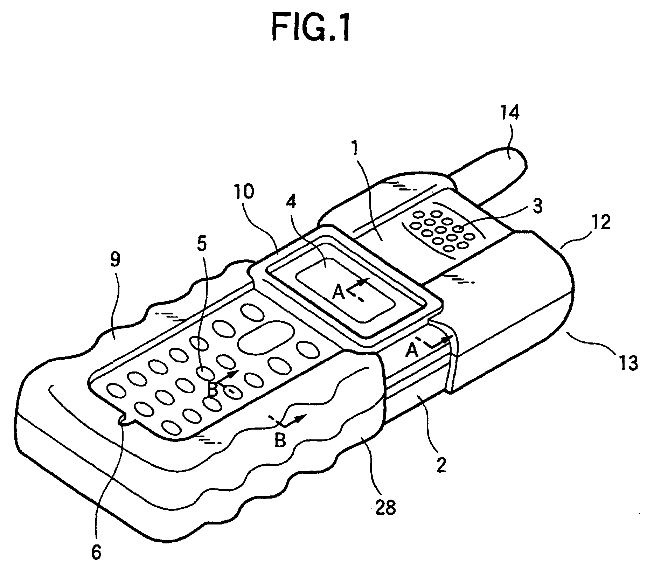

Fig. 1 is a perspective view showing the constitution of a portable telephone unit in an embodiment of the invention. As shown in Fig. 1, the portable telephone unit comprises an upper case 12 having a receiver 3, a microphone 6, an operational portion 5 including a plurality of function buttons such as a dial button, a menu button, and the like, and a display portion 4 for displaying input telephone number and the others; and a lower case 13 into which an antenna 14, a battery (not shown), and the like are inserted; and circuit substrates (not shown) that are accommodated in these upper case 12 and lower case 13. The aforesaid upper case 12 and lower case 13 have on their surfaces soft materials 9 and 28 that protrude more than hard materials 1 and 2.

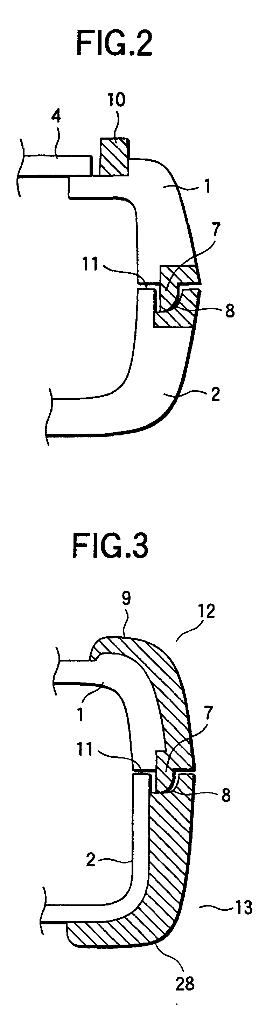

Further, as shown in Figs. 2 and 3, on the periphery of a joint surface 11 of the upper and lower cases, a water proof rib 7 formed of soft material and a waterproof groove 8 are formed integrally with the hard material 1 and the hard material 2, and the waterproof rib 7 is pressed against the waterproof groove 8 thereby to obtain waterproof ability.

According to the constitution of the invention, the integral molding of the soft material is limited to the surface of the hard material and the outside of the joint surface thereby to use a mold core in common at the hard material molding time and at the soft material molding time, and the common core moves alternately between a cavity for hard material molding and a cavity for soft material molding, whereby the simultaneous and integral molding of the hard material and soft material using the same mold can be performed.

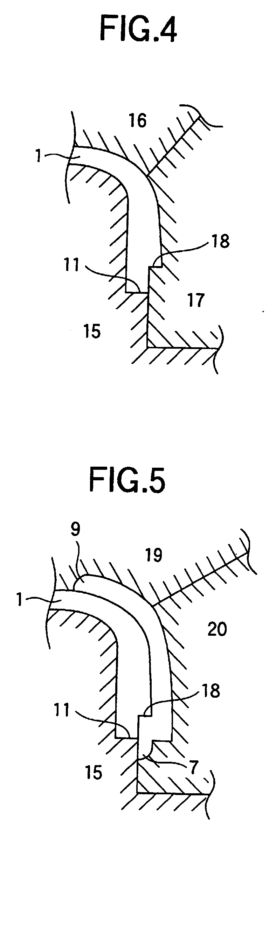

A first embodiment of the invention will be described below. Figs. 4 and 5 show respectively a manufacturing method of the portable telephone unit according to the invention. Fig. 4 shows the constitution of the mold when the hard resin portion 1 of the upper case 12 is molded (primary molding), and Fig. 5 shows the constitution of the mold when the soft resin portions 7 and 9 of the upper case 12 are molded (secondary molding).

The mold forming the hard resin portion 1 comprises a core 15, a primary cavity 16, and a primary cavity slide 17. After the hard resin is molded, firstly, the primary cavity slide 17 moves outward, and then the core 15 separates from the primary cavity 16 together with the hard resin portion 1, whereby the hard resin 1 is taken out from the primary cavity.

Next, without taking out the hard resin portion 1 from the mold, the core is slid or rotated to be moved and then constricted in relation to the cavity for the soft resin molding, whereby the hard resin portion 1 is taken into the soft resin molding. The cavity for the soft resin is formed of a secondary cavity body 19 having the shape of the soft material 9 that protrudes more than the hard material, and a secondary cavity slide 20 having a fan-shaped waterproof rib 7; and the protruding soft resin 9 is formed between the secondary cavity body 19 and the hard resin portion 1. Further, the waterproof rib 7 is molded outside the upper and lower case joint surface 11 and has a shape in which the fan-shaped section of the secondary cavity slide 20 is fitted to the straight surface of the common core 15.

As described above, according to the first aspect of the invention, the simultaneous molding can be performed using the same mold by the above manufacturing method. Therefore, it is possible to improve both the waterproof ability and the productivity of parts, and it is also possible to reduce the number of parts, the mold cost, and the assembling steps.

Further, in this embodiment, the waterproof rib is formed in the shape in which the fan-shaped section of the cavity slide is fitted to the straight surface of the common core, whereby machining of the mold can be simplified and fitting of the slide can be facilitated.

Further, in this embodiment, the deformation of the waterproof rib is performed in the waterproof groove formed of the soft material, whereby the repulsion power is relaxed, and the clearance between the upper and lower cases can be prevented. Further, since the soft material 9, 10, 28 that protrude more than the hard material are formed on the surfaces of the upper and lower cases 1, 2 in this embodiment, even when the portable telephone unit drops from other portions thereof than corners, the protruding soft material strikes against matter earlier than the hard material. Therefore, the shock-resistance can be improved more.

Further, as a means for heightening the effect of the shock-absorption by the soft material, there is a means that the surface of the soft material is formed of a plurality of convexities. A second embodiment of the invention will be described below with reference to Fig. 6.

Figs. 6A, 6B and 6C are three sectional views obtained by cutting the side surface of the case in parallel with the joint surface in the second embodiment of the invention. Since the shapes of any soft materials 9 have the plural convexities on their surfaces, the convex portions are deformed when the portable telephone unit drops, whereby the shock can be absorbed. In this connection, in the order of Fig. 6A, Fig. 6B and Fig. 6C, the effect of the shock relaxation becomes larger.

Further, by forming the grip portion of the upper and lower case from the soft material that is little in slip, the grip ability can be heightened more.

### Industrial Applicability

As clear from the above description, in the invention, the waterproof rib formed of the soft material is integrally constituted on the periphery of the joint surface of the upper and lower case formed of the hard material, and further the soft material that protrudes more than the hard material is formed on the surface of the upper and lower case. Hereby, an excellent portable telephone unit can be realized, in which the excellent waterproof ability and shock-resistance can be realized, and simultaneously the number of parts, mold cost and the assembling steps can be reduced.

## Claims

1. A portable telephone unit comprising a waterproof rib formed of a soft material provided on the periphery of a joint surface of upper and lower cases formed of hard material, that is, on a cavity side of a mold, integrally with said hard material, wherein said waterproof rib is fitted into a waterproof groove opposed thereto, thereby to join the upper and lower cases water-tightly to each other.

2. The portable telephone unit according to Claim 1, wherein the waterproof groove opposed to said waterproof rib is formed of the soft material.

3. The portable telephone unit according to Claim 1, wherein a leading end shape of said waterproof rib is formed of a fan-shaped section.

4. A portable telephone unit comprising soft material that protrudes more than hard material formed on surfaces of upper and lower cases formed of the hard material.

5. The portable telephone unit according to Claim 4, wherein the soft material formed on the surfaces of the upper and lower cases has a plurality of convexities.

6. A portable telephone unit comprising soft material which covers a grip portion of upper and lower case.

7. A manufacturing method of a portable telephone unit comprising steps of:
using a mold core in common at the hard material molding time and at the soft material molding time; and
moving the common core alternately between a cavity for soft material molding and a cavity for hard material molding,
whereby the simultaneous and integral molding of the hard material and the soft material can be performed using the same mold.
